# EUROPEAN PATENT SPECIFICATION

(11) **EP 3 996 477 B1**
(45) Date of publication and mention of the grant of the patent: **28.01.2026**
(21) Application number: 20835524.8
(22) Date of filing: 29.06.2020
(51) Int. Cl.: H05K 5/02, H04M 1/02, G06F 1/16

(54) **CASING STRUCTURE OF ELECTRONIC DEVICE**
GEHÄUSESTRUKTUR EINER ELEKTRONISCHEN VORRICHTUNG
STRUCTURE DE BOÎTIER DE DISPOSITIF ÉLECTRONIQUE

(30) Priority: 01.07.2019 CN 201910586568
(43) Date of publication of application: 11.05.2022
(73) Proprietor: Shenzhen Idata Machine Vision Technology Co., Ltd., Shenzhen, Guangdong 518000 (CN)
(72) Inventor: WANG, Dongsheng, Guangzhou, Guangdong 510000 (CN); LIU, Jing, Shenzhen, Guangdong 518000 (CN); ZHANG, Lijing, Changsha, Hunan 410000 (CN); WANG, Zhenxi, Shenzhen, Guangdong 518000 (CN); LIU, Xianfu, Shenzhen, Guangdong 518000 (CN)
(74) Representative: Meyer-Dulheuer MD Legal Patentanwälte PartG mbB
(86) International application number: PCT/CN2020/098695
(87) International publication number: WO 2021/000812

(56) References cited:
- WO-A1-2015/139444
- CN-A- 101 106 873
- CN-A- 101 872 851
- CN-A- 106 358 392
- CN-A- 110 505 775
- CN-U- 206 165 031
- CN-U- 207 782 886

## Description

### TECHNICAL FIELD

The present disclosure relates to a casing structure of an electronic device, in particular to a casing structure of an electronic device comprising a first casing, a second casing, at least one positioning-limiting portion and at least one abutment portion, wherein the casing structure is used for preventing gaps from being generated between mutually assembled casings.

### BACKGROUND

An existing hand-held terminal comprises a rear casing and a battery cover which are buckled with each other, in order to guarantee the buckling stability of the rear casing and the battery cover, the rear casing and the battery cover are usually locked through a locking piece, namely, the locking piece is mounted on the rear casing, and the rear casing and the battery cover are locked together through matching of a lock hook on the locking piece and a lock groove in the battery cover. When the battery needs to be taken out, the battery is taken out only by sliding the locking piece so that the locking hook is separated from the locking groove and then opening the battery cover. According to the structure, the tension between the middle part of the battery cover and the rear casing is weak, so that the battery cover is easy to bulge and deform, a gap is easy to generate between the battery cover and the rear casing, and the waterproof and dustproof effects are poor.

In the industry, a circle of buckles are additionally arranged on the periphery of the battery cover to be connected with clamping grooves in the rear casing, so that the tensioning force of the battery cover and the rear casing is increased. However, when the battery is replaced, due to the fact that the tensioning force of the battery cover and the rear casing is large, user operation is not convenient; and in the repeated opening and closing process of the battery cover, the buckles repeatedly rub against the side wall of the rear casing, and the buckles are easily abraded, so that the tensioning force of the battery cover and the rear casing is gradually reduced, and a gap is still easily generated between the battery cover and the rear casing. More importantly, when the hand-held terminal is impacted by external force, the battery cover is easily extruded and deformed, so that the buckle is separated from the clamping groove, the buckle cannot automatically reset into the clamping groove, and a large gap is formed between the battery cover and the rear casing.

Document CN 206165031U discloses a limit structure and an electronic equipment, wherein the limit structure is disposed on a housing, and a cover body that is engaged with each other. The limit structure includes a limit stop and a limit buckle to cooperate with the limit slot. The limit buckle is a convex portion, and at least one side of the limit buckle is an arc edge. When the limit buckle and the limit slot buckle, the limit buckle and the limit slot coincide with each other. During the repeated opening and closing of the cover body, the limit buckle rub against each other and wear out, resulting in a gradual reduction of the tension force between the cover bodies.

Aiming at the problems, the present disclosure provides a novel casing structure of an electronic device, and a novel method and novel technical means are adopted to solve the problems.

### SUMMARY

Aiming at the problems faced by the background art, the present disclosure aims to provide a casing structure of an electronic device, wherein the casing structure comprises a first casing, a second casing, at least one positioning-limiting portion and at least one abutment portion and wherein the casing structure is used for preventing gaps from being generated between mutually assembled casings.

To achieve the above purpose, the present disclosure adopts the following technological means:
The present disclosure provides a casing structure of an electronic device, the casing structure comprising a first casing and a second casing, the second casing being detachably mounted on the first casing and having a substantially rectangular shape, the main body portion having a first end and a second end arranged oppositely, the first end being rotatable about and supported by the first casing, such that the first casing and the second casing are in a relatively open state or closed state, and the casing structure of an electronic device comprising:
at least one position-limiting portion extending downward from a middle portion of the main body portion and located between the first end and the second end, the position-limiting portion having a position-limiting surface facing upward and sloping toward the first end; and
at least one abutment portion, the at least one abutment portion being located at a position of the first casing corresponding to the position-limiting portion and used for being in butt joint with the position-limiting portion, the abutment portion having a downward-sloping abutment surface that abuts the position-limiting surface.

When the second casing is rotated from the open state to the closed state, the position-limiting portion rotates with the first end as an axis to form a virtual rotating shaft, the position-limiting surface is substantially located on a cylindrical surface with the virtual rotating shaft as an axis, such that the position-limiting surface moves in a substantially arc-shaped path to a position obliquely below the abutment portion so as to contact the abutment surface.

The size of the position-limiting portion is gradually reduced from the root to the free end, a through hole is formed in the first casing and is adjacent to the abutment portion, and the free end of the position-limiting portion penetrates through the through hole.

A locking mechanism is arranged close to the second end and used for locking the second end with the first casing, wherein the locking mechanism comprises a locking piece mounted on the first casing or the second casing and clamping hooks arranged on the second casing or the first casing, and the locking piece moves between a locking position and an unlocking position so as to be separated from or clamped with the clamping hooks.

At least one buckle extends from the edge of the first end to the second end, at least one clamping groove is formed in the first casing and used for being clamped with the at least one buckle, the second casing rotates with the edge of the first end or the buckle as a supporting point to form the virtual rotating shaft, and the position-limiting surface is substantially located on a cylindrical surface with the virtual rotating shaft as an axis.

When the first casing and the second casing are in the closed state, the position-limiting portion and the abutment portion do not interfere with each other.

When the second casing and the first casing are in the closed state, the position-limiting portion and the abutment portion do not interfere with each other.

The number of the position-limiting portions is two, and the two position-limiting portions are located on the two opposite sides of the main body portion respectively.

The electronic device is a mobile terminal, the first casing is a battery casing, the second casing is a battery cover, and the first casing and the second casing are jointly used for accommodating a battery.

When the first casing and the second casing are in the closed state, the position-limiting surface is substantially parallel to the abutment surface.

Compared with the prior art, the present disclosure has the following beneficial effects:
The position-limiting portion is arranged on the second casing, the position-limiting portion extends downward from a middle portion of the main body portion and is located between the first end and the second end, the position-limiting portion has a position-limiting surface facing upward and sloping toward the first end, the abutment portion is located at a position of the first casing corresponding to the position-limiting portion and used for being in butt joint with the position-limiting portion, and the abutment surface arranged on the abutment portion faces downwards and is obliquely arranged towards the position-limiting portion so as to be in butt joint with the position-limiting surface; and when the second casing is supported on the first casing by the first end and is rotated from the open state to the closed state, the position-limiting portion rotates with the supporting point of the first end as an axis, such that the position-limiting surface moves in a substantially arc-shaped path to a position obliquely below the abutment portion so as to contact the abutment surface. Even if the electronic device is impacted by external force, the second casing is extruded and deformed, and the position-limiting portion moves upwards, the position-limiting portion returns to an original position due to the fact that the acting force of the abutment portion on the position-limiting portion faces the oblique lower part, a gap cannot be generated between the second casing and the first casing or the gap is automatically eliminated, and dust or water drops and other sundries are prevented from entering the electronic device; and due to the fact that the position-limiting surface substantially moves to the oblique lower part of the abutment portion along the arc track, in the buckling process of the second casing and the first casing, the position-limiting portion and the abutment portion cannot generate strong interference, abrasion cannot be generated even if long-term repeated opening and closing are conducted, when the second casing is opened, the interference force of the first casing does not need to be resisted, and opening and closing are convenient and labor-saving.

### BRIEF DESCRIPTION OF THE DRAWINGS

FIG. 1 is a space diagram of an electronic device in the present disclosure;
FIG. 2 is an exploded stereoscopic diagram of an electronic device in the present disclosure;
FIG. 3 is a section view in A-A direction in FIG. 1; and
FIG. 4 is a schematic diagram when a second casing is in an open state in the figure.

Reference signs in the detailed description of the embodiments:

| | | | | |
|---|---|---|---|---|
| Electroni c device 100 | First casing 1 | Clam ping groove 11 | Ab utment portion 12 | Abutm ent surface 121 |
| Through hole 13 | Seco nd casing 2 | Main body portion 21 | Firs t end 211 | Buckle 212 |
| Second end 213 | Cla mping hook 214 | Positi on-limiting portion 22 | Pos ition-limiti ng surface 221 | Lockin g mechanism 3 |
| Locking piece 31 | Push button 311 | Protr uding block 312 | | |

### DETAILED DESCRIPTION OF THE EMBODIMENTS

To facilitate better understanding of the purposes, structures, features, effects and the like of the present disclosure, the present disclosure is further described in conjunction with the attached figures and detailed description of the embodiments.

The electronic device 100 in the present disclosure comprises at least one of a smart phone, a tablet personal computer (PC), a mobile phone, a video phone, an electronic book reader, a desktop PC, a notebook computer, a netbook computer, a workstation, a server, a personal digital assistant (PDA), a portable multimedia player (PMP), an MP3 player, a medical device, a camera and a wearable device. The wearable device comprises at least one application accessory type of device (such as a watch, a ring, a bracelet, an anklet, a necklace, glasses, contact lenses) and a head-mounted-device (HMD), a textile, or a clothing-integrated device (such as an electronic garment). According to various embodiments, the electronic device comprises a television (TV), a digital video disk (DVD) player, an audio player, an air conditioner, a cleaner, an oven, a microwave oven, a washing machine, an air purifier, a set top box, a home automation control panel, a security control panel, a media box (such as Samsung HomeSyncTM, Apple TVTM, or Google TVTM), a game console (such as XboxTM, PlayS tationTM), an electronic dictionary, an electronic key, a camcorder and an electronic frame.

According to an alternative embodiment, the electronic device comprises at least one of medical devices (such as portable medical measuring devices including a blood glucose meter, a heart rate monitor, a blood pressure monitor and a body temperature thermometer, a magnetic resonance angiography (MRA) device, a magnetic resonance imaging (MRI) device, a computed tomography (CT) device, a video camera and a microwave scanner), a navigation device, a global navigation satellite system (GNSS), an event data recorder (EDR), a flight data recorder (FDR), an automotive infotainment device, marine electronics (such as a marine navigation system and a gyrocompass), aviation electronics (avionics), a security device, an automotive mainframe, an industrial or household robot, a drone, an automatic teller machine (ATM), a point of sales (POS) terminal and an Internet-of-things (IoT) device (such as a light bulb, a sensor, a water sprinkler system, a fire alarm system, a temperature controller, a street lamp, a toaster, fitness equipment, a hot water tank, a heater and a boiler). According to an embodiment of the present disclosure, the electronic device comprises at least one of furniture, a part of a building/structure, a part of a vehicle, an electronic board, an electronic signature receiving device, a projector, and a sensor (such as a water meter, an electricity meter, a gas meter and an electric wave meter). According to various embodiments of the present disclosure, the electronic device is flexible or a combination of at least two of the above-mentioned devices. According to an embodiment of the present disclosure, the electronic device is not limited to the above-mentioned devices. In the present disclosure, the term "user" means a person who uses an electronic device or a device (such as an artificial intelligence electronic device) that uses an electronic device.

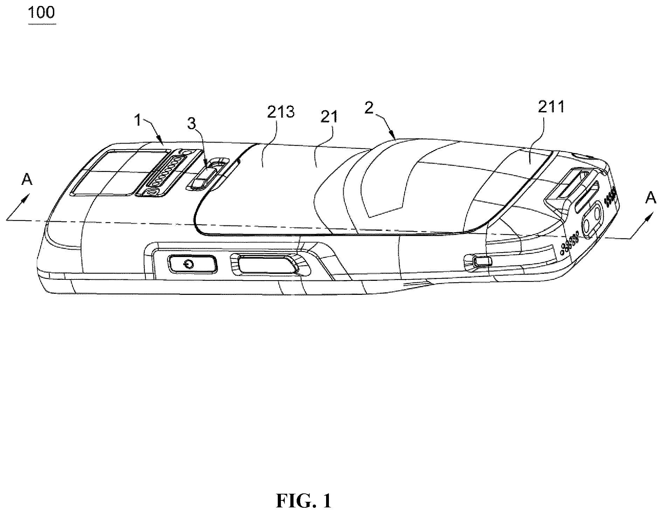

As shown in FIG. 1, a casing structure of an electronic device 100 in the present disclosure is described with a PDA in a mobile terminal as an example.

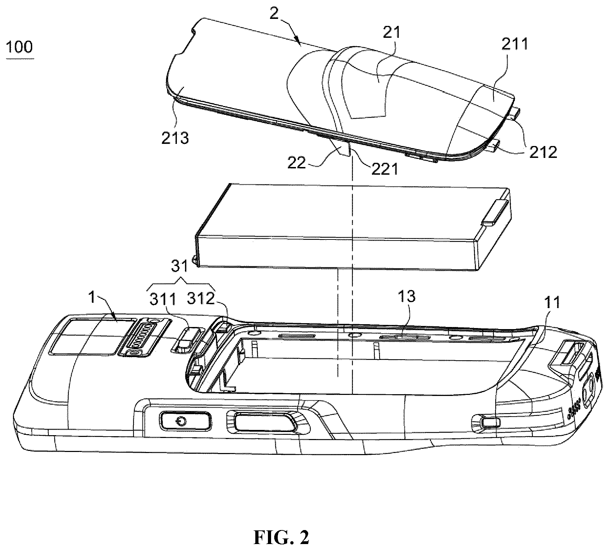

As shown in FIG. 1 and FIG. 2, the electronic device 100 is placed with the back side facing upwards, and the electronic device 100 comprises a first casing 1 and a second casing 2, and the second casing 2 is detachably mounted on the first casing 1. In the embodiment, the first casing 1 is a battery casing, the second casing 2 is a battery cover, and the first casing and the second casing are jointly surrounded to form a battery jar (unmarked, similarly hereinafter) and used for accommodating a battery (unmarked, similarly hereinafter).

The second casing 2 has a main body portion 21 having a substantially rectangular shape, along the length direction of the main body portion 21 the main body portion 21 has a first end 211 and a second end 213 arranged oppositely, the first end 211 is rotatable about and supported by the first casing 1, such that the first casing 1 and the second casing 2 are in a relatively open state or closed state. Two buckles 212 extend from the edge of the first end 211 to the second end 213, two clamping grooves 11 are formed in the first casing 1 and used for being clamped with the two buckles 212.

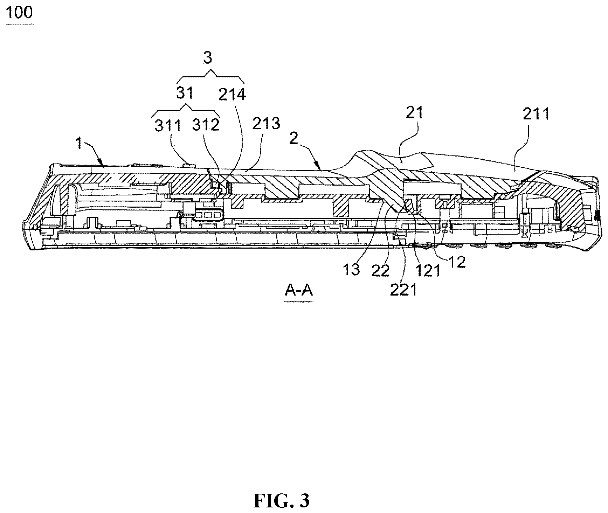

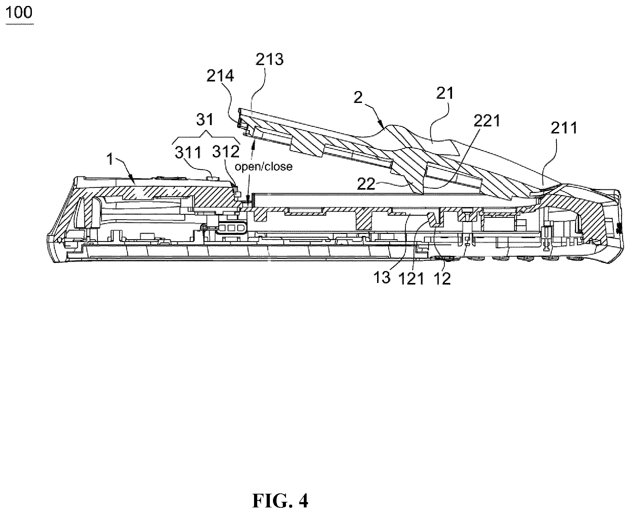

As shown in FIG. 3 and FIG. 4, the middle positions of the left side and the right side of the lower surface of the main body portion 21 respectively extend downwards to form a position-limiting portion 22, and the size of the position-limiting portion 22 is gradually reduced from the root to the free end, so that the position-limiting portion 22 is substantially in an inverted trapezoid shape. A position-limiting surface 221 is formed on the surface, facing the first end 211, of the position-limiting portion 22, the position-limiting surface 221 is slightly oblique upwards, and the position-limiting surface 221 is arranged to be a plane in order to facilitate forming machining of a mold; in other embodiments, more position-limiting portions 22 is arranged as required, the closer the position-limiting portions 22 are to the first end 211, the smaller the inclination is, namely, the larger the included angle with the vertical direction is, the farther the position-limiting portions 22 are from the first end 211, the larger the inclination is, namely, the closer the position-limiting surface 221 is to the vertical shape; and in other embodiments, the position-limiting surface 221 is configured as a curved surface. An abutment portion 12 is located at a position of the first casing 1 corresponding to each position-limiting portion 22 and used for being in butt joint with the position-limiting portion 22, the abutment portion 12 is provided with an abutment surface 121 obliquely arranged towards the oblique lower part, and when the first casing 1 is in a closed state, the abutment surface 121 is substantially parallel to the position-limiting surface 221; and a through hole 13 is formed in the first casing 1 to be adjacent to the abutment portion 12, and the through hole 13 is used for allowing the free end of the position-limiting portion 22 to penetrate through.

A locking mechanism 3 is arranged on the electronic device 100 close to the second end 213 of the first casing 1 and used for locking the second end 213 of the second casing 2 with the first casing 1, and then the second casing 2 is mounted and fixed on the first casing 1 in cooperation with the position-limiting portion 22 and the two buckles 212 of the first end 211. In the embodiment, the locking mechanism 3 comprises two clamping hooks 214 arranged at the end of the second end 213 and a locking piece 31 mounted on the first casing 1, the locking piece 31 comprises a push button 311 and two protruding blocks 312 located at the two ends of the push button 311, the two protruding blocks 312 are used for being clamped with the two clamping hooks 214 respectively, and the locking piece 31 moves between a locking position and an unlocking position by pushing the push button 311 left and right, so that the protruding block 312 is separated from or clamped with the clamping hook 214. In other embodiments, the locking piece 31 is mounted on the second casing 2, while the first casing 1 is correspondingly provided with two clamping hooks 214 to cooperate with the locking piece 31. In other embodiments, the locking piece 31 is arranged to be of a cam structure or other suitable structures.

When the battery is mounted, the battery is firstly mounted in the battery jar, then the two buckles 212 of the first end 211 are aligned with the two clamping grooves 11 in the first casing 1 to be inserted, the first end 211 is supported on the first casing 1, according to different structures, the edge of the first end 211 is supported on the first casing 1, and the two buckles 212 is also supported on the first casing 1. In the embodiment, the second casing 2 is supported on the first casing 1 by using the edge of the first end 211 as a supporting point, and at the moment, the second casing 2 and the first casing 1 are in a relatively open state. The second casing 2 is rotated to be in a closed state with the first casing 1, in the whole process, the second casing 2 rotates with the edge of the first end 211 as an axis to form a virtual rotating shaft, and the position-limiting surface 221 is substantially located on a cylindrical surface with the virtual rotating shaft as the axis, namely, the distances between all points on the position-limiting surface 221 and the virtual rotating shaft are substantially the same, the position-limiting surface 221 roughly performs circular motion along the cylindrical surface, the free end of the position-limiting portion 22 penetrates through the through hole 13 to the oblique lower part of the abutment portion 12, the position-limiting surface 221 and the abutment surface 121 form surface contact, and in the whole process, the position-limiting surface 221 and the abutment surface 121 do not interfere with each other. The push button 311 is pushed, so that the locking piece 31 slides to the locking position, and the installation of the battery is completed.

When the electronic device 100 is impacted by the outside, the second casing 2 deforms, the middle of the second casing 2 is instantly bulged, a gap is formed between the second casing 2 and the first casing 1, the position-limiting surface 221 interferes with the abutment surface 121, and the position-limiting surface 221 cannot be separated from the abutment surface 121 when sliding upwards along the abutment surface 121 due to the fact that the contact area of the position-limiting surface 221 and the abutment surface 121 is large, and the abutment surface 121 further generates an inclined downward acting force on the position-limiting surface 221, so that the position-limiting portion 22 moves downwards to return to an original position, and the gap between the second casing 2 and the first casing 1 is eliminated.

In the embodiment, the first end 211 of the second casing 2 is positioned on the first casing 1 with the buckles 212; and in other embodiments, a hinge structure is arranged at the first end 211 of the second casing 2 to hinge the first end 211 to the first casing 1.

The casing structure of an electronic device in the present disclosure has the following beneficial effects:
The position-limiting portion 22 is arranged on the second casing 2, the position-limiting portion 22 extends downward from a middle portion of the main body portion 21 and is located between the first end 211 and the second end 213, the position-limiting portion 22 has a position-limiting surface 221 facing upward and sloping toward the first end 211, the abutment portion 12 is located at a position of the first casing 22 corresponding to the position-limiting portion and used for being in butt joint with the position-limiting portion 22, and the abutment surface 121 arranged on the abutment portion 12 faces downwards and is obliquely arranged towards the position-limiting portion 22; and when the second casing 2 is supported on the first casing 1 by the first end 211 and is rotated from the open state to the closed state, the position-limiting portion 22 rotates with the supporting point of the first end 211 as an axis, so that the position-limiting surface 221 moves in a substantially arc-shaped path to a position obliquely below the abutment portion 12 so as to contact the abutment surface 121. Even if the electronic device 100 is impacted by external force, the second casing 2 is extruded and deformed, and the position-limiting portion 22 moves upwards, the position-limiting portion 22 returns to an original position due to the fact that the acting force of the abutment portion 12 on the position-limiting portion 22 faces the oblique lower part, a gap cannot be generated between the second casing 2 and the first casing 1 or the gap is automatically eliminated, and dust or water drops and other sundries are prevented from entering the electronic device 100; and due to the fact that the position-limiting surface 221 substantially moves to the oblique lower part of the abutment portion 12 along the arc track, in the buckling process of the second casing 2 and the first casing 1, the position-limiting portion 22 and the abutment portion 12 cannot generate strong interference, abrasion cannot be generated even if long-term repeated opening and closing are conducted, when the second casing 2 is opened, the interference force of the first casing 1 does not need to be resisted, and opening and closing are convenient and labor-saving.

The above are only the description of preferred embodiments of the present disclosure and not intended to limit the patent scope of the present disclosure, and equivalent technical changes based on the specification and the attached figures of the present disclosure shall similarly fall within the scope of patent protection of the present disclosure.

## Claims

1. A casing structure of an electronic device (100), the casing structure comprising
a first casing (1) and a second casing (2), the second casing (2) being detachably mounted on the first casing (1) and having a substantially rectangular shape, a main body portion (21) having a first end (211) and a second end (213) arranged oppositely, the first end (211) being rotatable about and supported by the first casing (1), such that the first casing (1) and the second casing (2) are in a relatively open state or closed state, and the casing structure of an electronic device comprising:
at least one position-limiting portion (22) extending downward from a middle portion of the main body portion (21) and located between the first end (211) and the second end (213), the position-limiting portion (22) having a position-limiting surface (221) facing upward and sloping toward the first end; and
at least one abutment portion (12), the at least one abutment portion (12) being located at a position of the first casing (1) corresponding to the position-limiting portion (22) and used for being in butt joint with the position-limiting portion (22), the abutment portion (12) having a downward-sloping abutment surface (121) that abuts the position-limiting surface (221), wherein
when the second casing (2) is rotated from the open state to the closed state, the position-limiting portion (22) is configured to rotate with the first end (211) as an axis to form a virtual rotating shaft, the position-limiting surface (221) is substantially located on a cylindrical surface with the virtual rotating shaft as an axis, and the position-limiting surface (221) is configured to move in a substantially arc-shaped path to a position obliquely below the abutment portion (12) so as to contact the abutment surface (121);
wherein at least one buckle (212) extends from the edge of the first end (211) to the second end (213), at least one clamping groove (11) is formed in the first casing (1) and configured for being clamped with the at least one buckle (212), and the second casing (2) configured to rotate with the edge of the first end (211) or the buckle (212) as a supporting point to form the virtual rotating shaft;
wherein when the electronic device (100) is impacted by the outside, the second casing (2) may deform, the position-limiting surface (221) slides upward along the abutment surface (121), a gap is formed between the second casing (2) and the first casing (1), the position-limiting surface (221) interferes with the abutment surface (121), and the abutment surface (121) further generates an inclined downward acting force on the position-limiting surface (221), so that the position-limiting portion (22) moves downwards to return to an original position, and the gap between the second casing (2) and the first casing (1) is eliminated;
wherein the size of the position-limiting portion (22) is gradually reduced from a root to a free end, a through hole (13) is formed in the first casing (1) and is adjacent to the abutment portion (12), and the free end of the position-limiting portion (22) penetrates through the through hole (13).

2. The casing structure of an electronic device (100) according to claim 1, wherein when the first casing (1) and the second casing (2) are in the closed state, the position-limiting portion (22) and the abutment portion (12) do not interfere with each other.

3. The casing structure of an electronic device (100) according to claim 1, wherein when the second casing (2) and the first casing (1) are in the closed state, the position-limiting portion (22) and the abutment portion (12) do not interfere with each other.

4. The casing structure of an electronic device (100) according to claim 1, wherein the number of the position-limiting portions (22) is two, and the two position-limiting portions (22) are located on the two opposite sides of the main body portion (21) respectively.

5. The casing structure of an electronic device (100) according to claim 1, wherein a locking mechanism (3) is arranged close to the second end (213) and used for locking the second end (213) with the first casing (1).

6. The casing structure of an electronic device (100) according to claim 6, wherein the locking mechanism (3) comprises a locking piece (3) mounted on the first casing (1) or the second casing (2) and clamping hooks (214) arranged on the second casing (2) or the first casing (1), and the locking piece (3) can move between a locking position and an unlocking position so as to be separated from or clamped with the clamping hooks (214).

7. The casing structure of an electronic device (100) according to claim 1, wherein the electronic device is a mobile terminal, the first casing (1) is a battery casing, the second casing (2) is a battery cover, and the first casing (1) and the second casing (2) are jointly used for accommodating a battery.

8. The casing structure of an electronic device (100) according to claim 1, wherein when the first casing (1) and the second casing (2) are in the closed state, the position-limiting surface (221) is substantially parallel to the abutment surface (121).

## Patentansprüche

1. Gehäusestruktur für ein Elektronikgerät (100), die ein erstes Gehäuse (1) und ein zweites Gehäuse (2) aufweist, wobei das zweite Gehäuse (2) abnehmbar am ersten Gehäuse (1) angebracht ist, das zweite Gehäuse (2) einen im Wesentlichen quadratischen Hauptkörper (21) aufweist, der ein erstes Ende (211) und ein gegenüberliegendes zweites Ende (213) aufweist, wobei das erste Ende (211) drehbar auf dem ersten Gehäuse (1) abgestützt ist, sodass das erste Gehäuse (1) und das zweite Gehäuse (2) entweder in einer geöffneten Stellung oder in einer geschlossenen Stellung zueinander angeordnet werden können, und wobei Gehäusestruktur für ein Elektronikgerät Folgendes umfasst:
mindestens einen Begrenzungsabschnitt (22), der sich von der Mitte des Hauptkörpers (21) nach unten erstreckt und zwischen dem ersten Ende (211) und dem zweiten Ende (213) angeordnet ist, wobei der Begrenzungsabschnitt (22) eine nach oben gerichtete und zum ersten Ende hin geneigte Begrenzungsfläche (221) aufweist;
mindestens ein Andockabschnitt (12), der am ersten Gehäuse (1) gegenüber dem Begrenzungsabschnitt (22) angeordnet ist, wobei der Andockabschnitt (12) eine nach unten geneigte Andockfläche (121) aufweist, die zum Andocken an die Begrenzungsfläche (221) dient;
wobei beim Drehen des zweiten Gehäuses (2) aus der geöffneten in die geschlossene Stellung der Begrenzungsabschnitt (22) um das erste Ende (211) als Drehachse rotiert, um eine virtuelle Drehachse zu bilden, wobei die Begrenzungsfläche (221) im Wesentlichen auf einer zylindrischen Oberfläche mit der virtuellen Drehachse als Achse angeordnet ist, und wobei die Begrenzungsfläche (221) im Wesentlichen entlang der kreisförmigen Bogenbahn zur schrägen Unterseite des Andockabschnitts (12) bewegt und in Kontakt mit der Andockfläche (121) kommt;
wobei sich der Rand des ersten Endes (211) mit mindestens einem Schnappverschluss (212) nach hinten zum zweiten Ende (213) erstreckt, und dass das erste Gehäuse (1) mit mindestens einem Steckschlitz (11) versehen ist, der in den mindestens einen Schnappverschluss (212) eingreift, wobei das zweite Gehäuse (2) sich um den Rand des ersten Endes (211) oder dem Schnappverschluss (212) als Drehpunkt dreht und eine virtuelle Drehachse bildet;
wenn das elektronische Gerät (100) von außen beeinflusst wird, kann sich das zweite Gehäuse (2) verformen, die Begrenzungsfläche (221) gleitet entlang der Andockfläche (121) nach oben, es entsteht ein Spalt zwischen dem zweiten Gehäuse (2) und dem ersten Gehäuse (1), die Begrenzungsfläche (221) greift in die Andockfläche (121) ein, und die Andockfläche (121) erzeugt weiterhin eine nach unten gerichtete Kraft auf die Positionsbegrenzungsfläche (221), sodass sich der Begrenzungsabschnitt (22) nach unten bewegt, um in seine ursprüngliche Position zurückzukehren, und der Spalt zwischen dem zweiten Gehäuse (2) und dem ersten Gehäuse (1) verschwindet;
wobei der Begrenzungsabschnitt (22) eine von dessen Wurzelende zu dessen freien Ende hin allmählich abnehmende Abmessung aufweist, und dass in dem ersten Gehäuse (1) ein Durchgangsloch (13) vorgesehen ist, das an den Andockabschnitt (12) angrenzt, wobei das Durchgangsloch (13) dazu dient, das freie Ende des Begrenzungsabschnitts (22) hindurchzuführen.

2. Gehäusestruktur für ein Elektronikgerät nach Anspruch 1, **dadurch gekennzeichnet, dass** der Begrenzungsabschnitt (22) und der Andockabschnitt (12) interferenzfrei zueinander angeordnet sind, wenn das erste Gehäuse (1) und das zweite Gehäuse (2) im geschlossenen Zustand sind.

3. Gehäusestruktur für ein Elektronikgerät nach Anspruch 1, **dadurch gekennzeichnet, dass** während des Schließvorgangs des zweiten Gehäuses (2) mit dem ersten Gehäuse (1) der Begrenzungsabschnitt (22) und der Andockabschnitt (12) interferenzfrei zueinander angeordnet sind.

4. Gehäusestruktur für ein Elektronikgerät nach Anspruch 1, **dadurch gekennzeichnet, dass** die Anzahl der Begrenzungsabschnitt (22) zwei ist, die an beiden gegenüberliegenden Seiten des Hauptkörpers (21) angeordnet sind.

5. Gehäusestruktur für ein Elektronikgerät nach Anspruch 1, **dadurch gekennzeichnet, dass** ein Verriegelungsmechanismus (3) nahe dem zweiten Ende (213) vorgesehen ist, um das zweite Ende (213) mit dem ersten Gehäuse (1) zu verriegeln.

6. Gehäusestruktur für ein Elektronikgerät nach Anspruch 5, **dadurch gekennzeichnet, dass** der Verriegelungsmechanismus (3) ein Verriegelungsteil (3), das an dem ersten Gehäuse (1) oder dem zweiten Gehäuse (2) angebracht ist, und einen Schnapphaken (214), der an dem zweiten Gehäuse (2) oder dem ersten Gehäuse (1) angeordnet ist, umfasst, wobei das Verriegelungsteil (3) zwischen einer Verriegelungsposition und einer Entriegelungsposition beweglich ist, um sich von dem Schnapphaken (214) zu lösen oder mit diesem zusammenzuschnappen.

7. Gehäusestruktur für ein Elektronikgerät nach Anspruch 1, **dadurch gekennzeichnet, dass** das Elektronikgerät ein mobiles Endgerät ist, wobei das erste Gehäuse (1) ein Batteriegehäuse und das zweite Gehäuse (2) eine Batterieabdeckung ist, die zusammen zur Aufnahme der Batterie verwendet werden.

8. Gehäusestruktur für ein Elektronikgerät nach Anspruch 1, **dadurch gekennzeichnet, dass** in einem zusammengefügten Zustand des ersten Gehäuses (1) und des zweiten Gehäuses (2) die Begrenzungsfläche (221) und die Andockfläche (121) im Wesentlichen parallel zueinander verlaufen.

## Revendications

1. Structure de coque pour dispositif électronique (100), comprenant une première coque (1) et une deuxième coque (2), la deuxième coque (2) étant montée de manière amovible sur la première coque (1), la deuxième coque comportant une partie principale de forme sensiblement quadrilatérale, la partie principale (21) ayant une première extrémité (211) et une deuxième extrémité opposées (213), la première extrémité (211) pouvant être supportée en rotation sur la première coque (1), permettant aux deux coques (1, 2) d'être dans un état ouvert l'une par rapport à l'autre ou un état encliqueté, **caractérisée en ce qu'**elle comprend:
• au moins une partie de limitation (22) s'étendant vers le bas depuis une zone centrale de la partie principale (21) entre la première et la deuxième extrémité (211, 213), la partie de limitation (22) ayant une surface de limitation (221) orientée vers le haut et inclinée vers la première extrémité ;
• au moins une partie d'accouplement (12) située sur la première coque (1) à une position correspondant à la partie de limitation (22) et apte à coopérer avec celle-ci, ladite partie d'accouplement (12) ayant une surface d'accouplement (121) inclinée obliquement vers le bas et destinée à coopérer avec la surface de limitation (221);
• lorsque la deuxième coque (2) pivote de l'état ouvert vers l'état encliqueté autour de la première extrémité (211) servant d'axe pour former un axe de rotation virtuel, la surface de limitation (221) étant sensiblement située sur une surface cylindrique ayant ledit axe de rotation virtuel comme centre d'axe, la surface de limitation (221) se déplaçant sensiblement le long de ladite surface cylindrique sur une trajectoire arquée jusqu'à une position située obliquement au-dessous de la partie d'accouplement (12), en contact avec la surface d'accouplement (121);
• **caractérisée en ce que** le bord (212) de la première extrémité (211) s'étend dans une direction s'éloignant de la deuxième extrémité (213) pour former au moins un crochet d'encliquetage, la première coque (1) comportant au moins une rainure (11) d'encliquetage destinée à coopérer avec ledit crochet d'encliquetage, la deuxième coque (2) pivotant autour dudit bord (212) ou dudit crochet (211) servant de point d'appui pour définir ledit axe de rotation virtuel;
lorsque le dispositif électronique (100) est impacté par l'extérieur, le deuxième boîtier (2) peut se déformer, la surface de limitation de position (221) glisse vers le haut le long de la surface d'appui (121), un espace se forme entre le deuxième boîtier (2) et le premier boîtier (1), la surface de limitation de position (221) interfère avec la surface d'appui (121), et la surface d'appui (121) génère en outre une force inclinée vers le bas agissant sur la surface de limitation de position (221), de sorte que la partie de limitation de position (22) se déplace vers le bas pour revenir à une position d'origine, et l'espace entre le deuxième boîtier (2) et le premier boîtier (1) est éliminé;
**caractérisée en ce que** la ou chaque partie de limitation (22) présente une section qui diminue progressivement de sa base vers son extrémité libre, la première coque (1) comportant un trou traversant (13) adjacent à la partie d'accouplement (12), ledit trou traversant (13) étant apte à laisser passer l'extrémité libre de la partie de limitation (22).

2. Structure de coque selon la revendication 1, **caractérisée en ce que**, lorsque la première coque (1) et la deuxième coque (2) sont dans l'état encliqueté, la partie de limitation (22) et la partie d'accouplement (12) ne sont pas en interférence.

3. Structure de coque selon la revendication 1, **caractérisée en ce que**, pendant le processus d'encliquetage de la deuxième coque (2) avec la première coque (1), la partie de limitation (22) et la partie d'accouplement (12) ne sont pas en interférence.

4. Structure de coque selon la revendication 1, **caractérisée en ce que** la structure comprend deux parties de limitation (22) disposées sur des côtés opposés de la partie principale (21).

5. Structure de coque selon la revendication 1, **caractérisée en ce qu'**elle comprend un mécanisme de verrouillage (3) disposé à proximité de la deuxième extrémité (213) et apte à verrouiller la deuxième extrémité (213) sur la première coque (1).

6. Structure de coque selon la revendication 5, **caractérisée en ce que** le mécanisme de verrouillage (3) comprend un élément de verrouillage (3) monté sur la première coque (1) ou la deuxième coque (2) et un crochet (214) disposé sur la deuxième coque (2) ou la première coque (1), l'élément de verrouillage (3) pouvant se déplacer entre une position de verrouillage et une position de déverrouillage afin de se désengager ou de s'engager avec le crochet (214).

7. Structure de coque selon la revendication 1, **caractérisée en ce que** le dispositif électronique est un terminal mobile, la première coque (1) est un boîtier de batterie, la deuxième coque (2) est un couvercle de batterie, les deux étant utilisés conjointement pour loger une batterie.

8. Structure de coque selon la revendication 1, **caractérisée en ce que**, lorsque la première coque (1) et la deuxième coque (2) sont dans l'état encliqueté, la surface de limitation (221) et la surface d'accouplement (121) sont sensiblement parallèles.
